**Europäisches Patentamt**

**European Patent Office**

**Office européen des brevets**

(11) Numéro de publication: **0 057 112**
**B1**

(12) **FASCICULE DE BREVET EUROPEEN**

(45) Date de publication du fascicule du brevet: **18.12.85**

(51) Int. Cl.⁴: **H 03 H 7/075**

(21) Numéro de dépôt: **82400007.9**

(22) Date de dépôt: **05.01.82**

(54) Filtres électriques autocorrigés en temps de propagation de groupe.

(30) Priorité: **23.01.81 FR 8101294**

(43) Date de publication de la demande:
**04.08.82 Bulletin 82/31**

(45) Mention de la délivrance du brevet:
**18.12.85 Bulletin 85/51**

(84) Etats contractants désignés:
**AT BE CH DE GB IT LI LU NL SE**

(56) Documents cités:
**ELECTRONIC INDUSTRIES, vol. 23, no. 1,
janvier 1964 PHILADELPHIA (US) E.C.
JOHNSON: "New developments in .....
designing bandpass filters"
IEEE TRANSACTIONS ON CIRCUITS AND
SYSTEMS, vol. CAS-24, no. 5, mai 1977 NEW
YORK (US) M. ORSUCCI et al.: "On the
synthesis of bandpass filters with bridged
topology" pages 252-260
IEEE TRANSACTIONS ON MICROWAVE
THEORY AND TECHNIQUES, vol. MTT-20, no.
4, avril 1972 NEW YORK (US) ALI E. ATTA:
"Narrow-Bandpass waveguide filters" pages
258-265**

(73) Titulaire: **THOMSON-CSF
173, Boulevard Haussmann
F-75379 Paris Cedex 08 (FR)**

(72) Inventeur: **Darmouni, Corinne
THOMSON-CSF SCPI 173, bld Haussmann
F-75360 PARIS CEDEX 08 (FR)**

(74) Mandataire: **Weinmiller, Jürgen et al
Zeppelinstrasse 63
D-8000 München 80 (DE)**

Courier Press, Leamington Spa, England.

EP 0 057 112 B1

## Description

La présente invention se rapporte, aux filtres électriques autocorrigés, et plus particulièrement aux filtres électriques autocorrigés à éléments à constantes localisées, du type passe bande, permettant de filtrer les signaux analogiques ou numériques dans une large bande de fréquence et permettant de corriger la distorsion du temps de propagation de groupe dans cette bande de fréquence.

De tels filtres sont particulièrement utiles dans les récepteurs de faisceaux hertziens. Dans une réalisation particulière de tels récepteurs on utilise des filtres électriques classiques. Les filtres classiques ne corrigent pas la distorsion du temps de propagation de groupe. Or très souvent, il apparait un inconvénient gênant pour la transmission du signal. Le temps de passage aux différentes fréquences de la bande passante n'est pas constant. En effet, le temps de propagation de groupe croit depuis une valeur faible pour les fréquences centrales de la bande passante jusqu'à une valeur élevée pour les fréquences limites de la bande passante. La fonction de correction du temps de propagation de groupe est réalisée par des réseaux correcteurs. Ces réseaux sont très souvent constitués par une ou plusieurs cellules comportant des éléments actifs. Lorsqu'il y a plusieurs cellules dans le réseau correcteur, chaque cellule est isolée dans cellules adjacentes, par un transistor. Ces réseaux correcteurs sont mis en cascade à la suite du filtre. Pour un récepteur de faisceaux hertziens, il est courant d'utiliser deux cellules en cascade pour la correction de phase. Les fréquences centrales des deux cellules sont situées de part et d'autre de la fréquence centrale du filtre passe-bande que l'on cherche à compenser.

Dans certaines applications en hyperfréquence, on utilise des filtres micro-onde à bande passante étroite. La fonction de correction du temps de propagation de groupe est réalisée en utilisant des cavités multiples couplées. La synthèse de ces filtres a été exposée dans la littérature technique comme le montrent les publications suivantes:

J. D. Rhodes "filtre généralisé à phase linéaire par cavité à couplage direct" IEEE Transactions MTT, Volume MTT 18, No. 6, juin 1970, pages 308—313;

A. E. Atia et autres "filtres guides d'ondes à bande étroite" IEEE Transactions MTT, Volume MTT 18, No. 4, avril 1972, pages 258—264 A. E. Atia et autres "Synthèse des cavités multiples couplées à bande étroite" IEEE Transactions CAS, Volume CAS-21, No. 5, septembre 1974, pages 649—655.

Les inconvénients de ces deux types de filtres sont présentés ci-dessous. Les filtres guides d'ondes à bande étroite et à cavités multiples couplées, ne peuvent pas être utilisés en basse fréquence ou en fréquence intermédiaire pour des raisons de dimensionnement, et d'encombrement trop important. Les filtres classiques munis de réseaux correcteurs nécessitent l'emploi d'alimentations spéciales pour les cellules actives. D'autre part, ils sont très encombrants et pas toujours très fiables.

Pour pallier ces difficultés, l'invention propose un filtre électrique autocorrigé à éléments à constants localisées, en temps de propagation de groupe, caractérisé en ce qu'il comporte une première et une deuxième entrée, un premier condensateur d'adaptation à la première entrée du filtre, huit résonateurs en cascade dont un premier est connecté d'une part à un premier noeud d'autre part à l'entrée E2, chaque résonateur étant constitué par un condensateur en parallèle sur une inductance, en ce qu'il comporte: une première, une deuxième, un troisième, une cinquième, une sixième, une septième inductance connectées respectivement entre le premier et le deuxième, le deuxième et le troisième, le troisième et le quatrième, le cinquième et le sixième, le sixième et le septième, le septième et le huitièmre résonateur, la première, la deuxième, la troisième inductance étant égale respectivement à la cinquième, à la sixième, à la septième inductance, en ce qu'il comporte une capacité connectée entre le quatrième et le cinquième résonateur, et en ce qu'il comporte une inductance connectée entre le premier et le huitième résonateur, et un condensateur connecté entre le troisième et le sixième résonateur.

D'autres particularités et avantages de l'invention apparaitront clairement dans la description suivante présentée à titre d'exemple non limitatif en regard des figures annexées suivantes:

la figure 1 représente la schéma de principe du filtre électrique autocorrigé;

la figure 2 représente une réalisation particulière du filtre selon l'invention;

la figure 3 représente les courbes d'amplitude et de temps de propagation de groupe pour une fréquence donnée, et une bande passante donnée;

la figure 4 représente un premier mode de branchement pour un résonateur;

la figure 5 représenté un deuxième mode de branchement pour un résonateur;

la figure 6 représente les courbes d'amplitude et de temps de propagation de groupe pour une deuxième et une troisième réalisation.

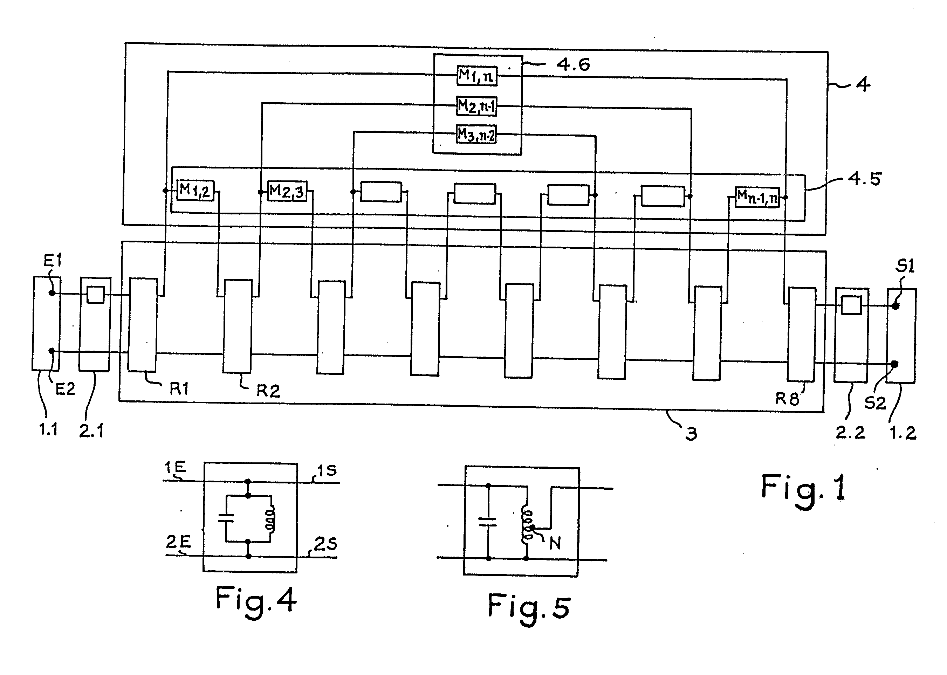

Le filtre électrique autocorrigé selon l'invention, dont le schéma de principe est représenté sur la figure 1, reçoit le signal d'entrée par une première paire de bornes d'accès E1, E2. Cette première paire de bornes d'accès constitue l'entrée du filtre. Un adaptateur d'impédance d'entrée 2.1 reçoit ce signal pour l'adapter et le transmettre aux moyens de filtrages. L'adaptateur d'impédance d'entrée 2.1 comporte 2 entrées et 2 sorties. Les deux sorties sont connectées aux entrées des moyens de filtrages 3. Ces moyens comprennent deux entrées, deux sorties, et sont constitués par un nombre n de résonateurs; n'étant un nombre entier, pair et supérieur à 2.

Sur le schéma de principe on s'est limité à n'égal à 8. Chaque résonateur comporte une première et une deuxième entrée, une première et une deuxième sortie. Les sorties d'un premier résonateur sont branchées directement ou indirectement aux entrées d'un deuxième résonateur. Ce branchement est qualifié de branchement en cascade. Les 2 sorties des moyens de filtrage 3, sont connectées à un adaptateur d'impédance de sortie 2.2. Les deux sorties des moyens de filtrage 3 sont les deux sorties du dernier résonateur. Les deux sorties de l'adaptateur d'impédance de sortie 2.2 sont connectées aux deuxièmes bornes d'accès du filtre S1 et S2. Ces deux bornes constituent les sorties du filtre. Les moyens d'autocorrection de temps de propagation de groupe 4 sont connectés aux moyens de filtrage 3 par l'intermédiaire de couplages adjacents 4.5. Les couplages adjacents sont constitués par des éléments à constantes localisées Mi,j. Chaque résonateur possède une sortie reliée à une entrée du résonateur adjacent par l'intermédiaire d'un couplage adjacente Mi,j.

Mi,j est tel que $i = 1, 2 \ldots, n-1$

$$j = i + 1$$

Il représente la couplage entre le $i^{ème}$ résonateur et le $j^{ème}$; le $j^{ème}$ étant le suivant. Les moyens d'autocorrection 4 comportent également des couplages non adjacents 4.6. Les couplages non adjacents sont constitués par des éléments à constantes localisées Mk,l. Ces couplages non adjacents sont connectés entre la première sortie du $k^{ème}$ résonateur et la première entrée du $l^{ème}$ résonateur avec k pouvant être égal à $1, 2 \ldots,$

$$\frac{n-2}{2}$$

l étant égal à $n-(k-1)$. Pour $n=8$ on a les couplages suivants:

M1,8 entre le premier résonateur et le huitième.
M2,7 entre le $2^{ème}$ résonateur et le $7^{ème}$.
M3,6 entre le $3^{ème}$ résonateur et le $6^{ème}$.

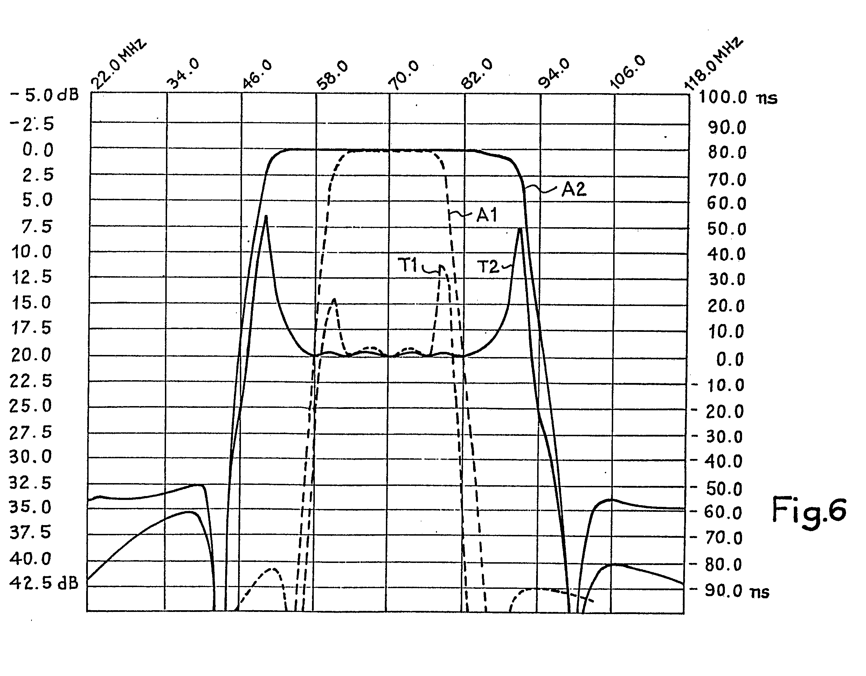

Les figures 4 et 5 représentent le schéma électrique des résonateurs.

La figure 4 représente un premier mode de branchement d'un couplage non adjacent sur une première sortie d'un résonateur.

La figure 5 représente une deuxième mode de branchement. les deux résonateurs représentés en figure 4 et 5 sont identiques dans leur constitution. Ils comportent classiquement un condensateur un parallèle sur une inductance (et éventuellement une nrésistance en parallèle sur l'inductance ou sur le condensateur pour amortir le résonateur) ayant des valeurs déterminées pour résonner à la fréquence d'accord. Les résonateurs sont munis de deux entrées et de deux sorties.

Sur la figure 4 résonateur possède une première entrée et une première sortie qui sont soumises à un même premier potentiel. La deuxième entrée et la deuxième sortie sont soumises à un même deuxième potentiel. Le couplage adjacent correspondant à ce résonateur est branché à la première sortie.

La figure 5 diffère de la figure 4 en un point. La première sortie est dans ce cas prise en un point milieu N de l'inductance. Le couplage non adjacent est connecté en ce point N.

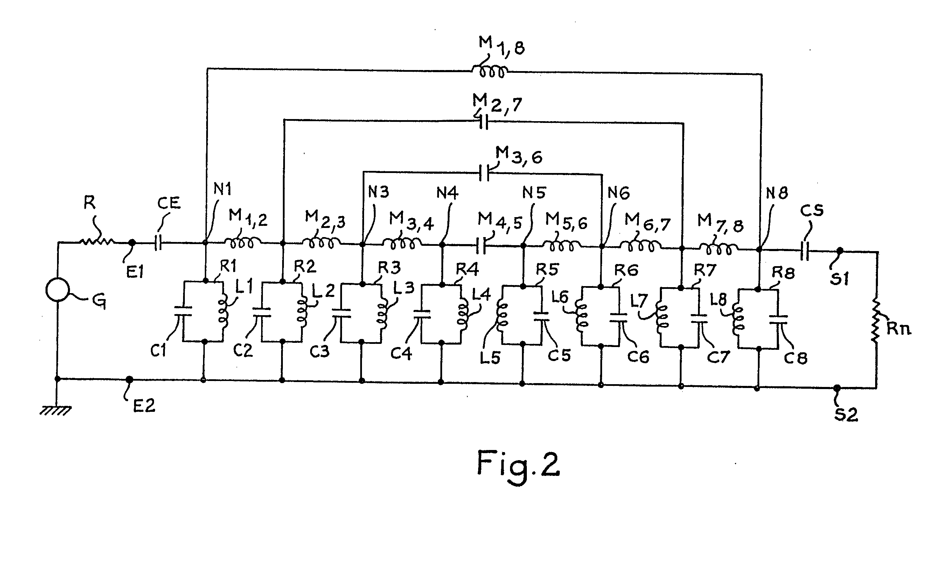

La figure 2 représente une réalisation particulière du filtre selon l'invention. Le filtre est réalisé pour une fréquence centrale qui se situe dans le domaine des fréquences intermédiaires aux alentours de 70 MHz. La bande passante à 3 dB est de 17,5 MHz. Le filtre présente donc une large bande passante selon les critères usuels.

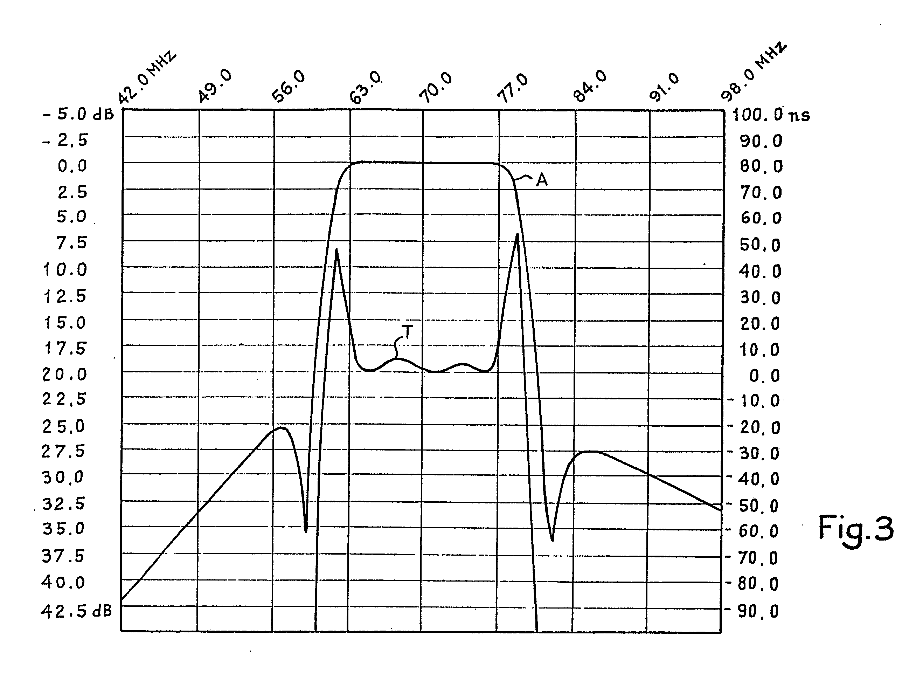

En se référant au schéma de principe de la figure 1, et en prenant le mode de réalisation représenté sur la figure 2, nous obtenons un filtre ayant les caractéristiques de l'invention. La correction de temps de propagation de groupe se traduit physiquement par une amélioration de la transmission du signal. Cette correction peut également s'observer sur l'allure de la courbe de temps de propagation qui est représentée sur la figure 3.

La description suivante se réfère donc au schéma de principe de la figure 1, et au schéma de réalisation de la figure 2. Le filtre est alimenté par un mélangeur de récepteur représenté sur le schéma par un générateur G, fournissant un signal de fréquence 70 MHz, et d'amplitude Vo. L'impédance interne R du générateur G est de 75. Le signal délivré par le générateur est appliqué à l'entrée du filtre entre les bornes d'accès E1 et E2. La deuxième entrée E2 du filtre est au potentiel O. Les adaptateurs d'impédance 2.1 et 2.2 sont des condensateurs CE et CS. Le condensateur CE est connecté entre l'entrée E1 et la première entrée du premier résonateur R1. Le condensateur CS est en série entre la sortie S1 et le dernier résonateur R8. Les deux condensateurs sont égaux à 24,96 pF dans cet exemple particulier, compte tenu des moyens de génération du signal. Les moyens de filtrage 3 sont constitués par 8 résonateurs R1, R2 ... R8. Chaque résonateur est identique à celui qui est représenté sur la figure 4. La première entrée 1E, et la première sortie 1S des résonateurs sont au même potentiel. Ce même potentiel constitue pour chaque résonateurs sont au même potentiel. Ce même potentiel constitue pour chaque résonateur, un noeud N1, N2 ... N8. Les deuxièmes entrées et deuxièmes sorties sont au potentiel O. Chaque résonateur est connecté au suivant, par l'intermédiaire des couplages adjacents, qui sont auto-inductifs sauf entre les deux résonateurs centraux où le couplage est capacitif. Le couplage non adjacent M1,8 entre $1^{er}$ et le $8^{ième}$ résonateur est auto-inductif. Les couplages non adjacent M2,7 et M3,6 respectivement entre le $2^{ième}$ et le $7^{ième}$ résonateur, et le $3^{ième}$ et le $6^{ième}$, résonateur sont capacitifs. Naturellement, il est clair que chaque inductance peut être remplacée par un élément équivalent soit une inductance bien déterminée en série avec un condensateur également bien déterminé soit une inductance en parallèle sur un condensateur soit trois inductances connectée en forme de "T", c'est-à-dire une première inductance en série avec une deuxième et une troisième connectée entre le point commun des deux première et un potentiel donné. Les valeurs des couplages adjacents ou non adjacents sont déterminées à partir de la méthode de synthèse des filtres. Cette méthode de synthèse consiste à trouver la matrice de couplage et les coefficients d'adaptation pour obtenir une fonction de transfert du filtre demandée. Elle est connue pour des bandes passantes étroites. Les résultats obtenus ne sont pas, par conséquents optimisés. Les calculs des éléments auto-inductifs et capacitifs sont réalisés à partir des équations suivantes:

$$\begin{cases} L_{ij}=\dfrac{R \cdot Rn}{2\pi \, fo \; M_{ij}} \\[3mm] C_{ij}=\dfrac{M_{ij}}{2\pi \, fo \, R \cdot Rn} \end{cases}$$

On calcule les éléments auto-inductifs et capacitifs des résonateurs à l'aide des équations suivantes:

$$\begin{cases} L=\dfrac{R \cdot Rn}{2\pi \, fo}\left(\dfrac{fp}{fo}-\dfrac{fo}{fp}\right) \\[3mm] C=\dfrac{1}{4\pi^2 fo^2 L} \end{cases}$$

fo est la frequence centrale du filtre, fp la fréquence supérieure de la dernière pulsation.

R est la résistance interne du générateur, Rn est la résistance de la charge.

$M_{i,j}$ est le terme d'ordre i,j de la matrice M de couplage.

On obtient un premier ensemble de résultats à partir de ces équations. On utilise la méthode d'optimisation de K. Madsen, H. Schiaer-Jacobsen, J. Voldby exposée dans la littérature technique, "Automated Minimax Design of NET works", IEEE-cir. and Syst., volume CAS-22; no. 10, octobre 1975, pages 791—795. Cette méthode d'optimisation permet de diminuer les écarts entra la réponse idéale du filtre $H(Fj)$ et le réponse réelle $H_0(Fj)$ pour une fréquence donnée Fj; Pour mesurer la qualité de la réponse réelle et guider l'optimisation afin d'améliorer la qualité, deux critères sont envisagés. D'une part on considère soit l'écart quadratique moyens de m fonction $H(Fj)$

$$Eq=\sqrt{\dfrac{1}{m}\sum_{j=1}^{m}[H(Fj)-H_0(Fj)]^2}$$

soit l'écart maximum de m fonctions $H(Fj)$

$$E_{max}=max_j \, (H(Fj)-H_0(Fj)).$$

La méthode d'optimisation tient compte des pertes sur chaque élément. Cette méthode suppose donc que chaque élément n'est pas parfait car il présente des caractéristiques résistive à la fréquence de résonance. Une inductance Lo est équivalente à une inductance L en série avec une résistance R égale à L2 fo/Q1 où Q1 est le coefficient de surtension de l'inductance L, R représente les pertes. Une condensateur Co est équivalent à un condensateur C en parallèle sur une résistance R égale à Qc/Q2 fo où Qc est le coefficient de surtension du condensateur C.

La méthode d'optimisation est une méthode itérative; à chaque itération, un problème non linéaire à résoudre est remplacé par une approximation linéaire. Lorsque la précision demandée est atteinte on arrête l'itération. On optimise encore les résultats en ajustant les couplages obtenus en fonction de la fréquence. On obtient une courbe d'amplitude présentant un minimum d'ondulation. Cette courbe présente également une symétrie arithmétique par rapport à la fréquence centrale Fo. On obtient ainsi également une symétrie arithmétique de la courbe de temps de propagation de groupe.

Pour l'exemple décrit, les résultats obtenus sont les suivants:

$M_{1,2}=M_{7,8}=530,37$ nH
$M_{2,3}=M_{6,7}=799,49$ nH
$M_{3,4}=M_{5,6}=1055,63$ nH
$M_{4,5}=3,52$ pF
$M_{3,6}=1,63$ pF
$M_{2,7}=0$
$M_{1,8}=10492,7$ nH

$C_1=C_8=26,11$ pF
$C_2=C_7=47,00$ pF
$C_3=C_6=41,53$ pF
$C_4=C_5=34,25$ pF.
L1=160 nH=L2=L3=L4=L5=L6=L7=L8.

Il y a dans cette réalisation particulière une symétrie des valeurs suivant un axe fictif qui passerait entre les deux résonateurs centraux R4 et R5.

La courbe d'amplitude A du filtre est représentée sur la figure 3. En abscisse sont portées les valeurs des fréquences en MHz. En ordonnées sont portées les atténuation d'amplitude (ou gain) en décibel. La symétrie arithmétique du filtre est traduite par une symétrie de la courbe par rapport à la fréquence centrale. Il y a symétrie arithmétique jusqu'à 25

dB de réjection hors bande. Ce qui signifie qu'il a encore une symétrie au-delà des fréquences de coupures pour une atténuation de 25 dB. Cette courbe d'atténuation possède des pentes raides ayant sensiblement la même allure aux deux fréquences de coupure. Ceci est due aux caractéristiques de symétrie arithmétique du filtre.

La courbe de temps de propagation de groupe T est représentée également sur la figure 3. En abscisse sont portées les fréquences en MHz. En coordonnées sont portés les temps en nano secondes. On constate que la courbe du temps de propagation de groupe a le même caractéristique que la courbe d'atténuation, à savoir, la symétrie arithmétique. On constate de plus, qu'il n'y a pratiquement pas de variation de temps de propagation entre 63 MHz et 77 MHz. La différence entre 77 MHz et 63 MHz représente à peu près les 80 pour cent de la bande utile du filtre. Il y a par conséquent une très bonne correction de variation de temps de propagation de groupe dans les 80 pour cent de la bande utile.

Deux autres réalisations ont été faites dans les mêmes conditions d'alimentation et de charge que dans la première réalisation avec des bandes passantes encore plus large que 17,5 MHz. L'une de ces deux réalisation est un filtre dont la fréquence centrale est aux alentours de 70 MHz et dont la bande passante est sensiblement égale à 20 MHz. Les courbes A1 d'amplitude et T1 de temps de propagation de groupe sont représenté sur la figure 6. L'autre réalisation est un filtre dont la fréquence centrale est aux alentours de 70 MHz et dont la bande passante est sensiblement égale à 36 MHz, soit à peu près 50% de la valeur de la fréquence centrale. Les courbes A2 d'amplitude et T2 de temps de propagation de groupe sont répresentée sur la figure 6. Ces deux filtres sont schématisés sur la figure 2.

Les résultats des couplages obtenus pour le filtre dont la bande passante est sensiblement égal à 20 MHz sont les suivants:

$M_{1,2}=M_{7,8}=550,8$ nH
$M_{2,3}=M_{6,7}=786,9$ nH
$M_{3,4}=M_{5,6}=1073,2$ nH
$M_{4,5}=2,8$ pF
$M_{3,6}=1,9$ pF
$M_{2,7}=0,5$ pF
$M_{1,8}=22723$ nH

$C_1=C_8=23,9$ pF
$C_2=C_7=43,4$ pF
$C_3=C_6=38,5$ pF
$C_4=C_5=31,9$ pF
$L1=L2=L3= - - - - =L8=175$ nH.

Les résultats des couplages obtenus pour le filtre dont la bande passante est sensiblement égale à 36 MHz sont les suivants:

$M_{1,2}=M_{7,8}=171,2$ nH
$M_{2,3}=M_{6,7}=223,7$ nH
$M_{3,4}=M_{5,6}=305,7$ nH
$M_{4,5}=12,2$ pF
$M_{3,6}=6,9$ pF
$M_{2,7}=0,5$ pF
$M_{1,8}=5959$ nH

$C_1=C_8=56,0$ pF
$C_2=C_7=76,5$ pF
$C_3=C_6=60,5$ pf
$C_4=C_5=42,3$ pF
$L1=L2=L3 - - - - =L8=160$ nH.

Les résultats obtenus pour ces deux autres réalisations correspondant à des bandes passantes plus larges, permettent d'obtenir une courbe d'atténuation A1, A2, présentant une symétrie arithmètique jusqu'à 25 dB de rejection hors bande et une courbe de temps de propagation de groupe T1, T2 présentant également une symètrie arithmètique et une très bonne correction de temps de propagation de groupe dans les 80 pour cent de la bande utile.

Les trois réalisations décrites ont subi un test de variation de température. Les essais ont été effectués entre une température minimale sensiblement égale à −30°C, et une température maximale sensiblement égale à +70°C. Après ces essais les courbes d'amplitude et de temps de propagation de groupe subissent des variations négligeables, et restent très pris de la réponse idéale du filtre.

Les résultat obtenus sont identiques à ceux que l'on obtient en utilisant des filtres plus des correcteurs, mais l'encombrement est réduit de 50%, et de plus aucun problème d'instabilité dû à la température ne s'est posé en raison de l'absence d'élément actif.

**Revendication**

Filtre électrique autocorrigé à éléments à constantes localisées en temps de propagation de groupe, caractérisé en ce qu'il comporte une première (E1) et une deuxième (E2) entrée, un premier condensateur d'adaptation (CE) à la première (E1) entrée du filtre, huit résonateurs en cascade dont un premier est connecté d'une part à un premier noeud (N1) d'autre part à l'entrée E2, chaque résonateur étant constitué par un condensateur (C1) en parallèle sur une inductance (L1), en ce qu'il comporte: une première $(M_{1,2})$, une deuxième $(M_{2,3})$, une troisième $(M_{3,4})$, une cinquième $(M_{5,6})$, une sixième $(M_{6,7})$, une septième $(M_{7,8})$ inductance connectées respectivement entre le premier (R1) et le deuxième (R2), le deuxième (R2) et le troisième (R3), le troisième (R3) et le quatrième (R4), le cinquième (R5) et le sixième (R6), le sixième (R6) et le septième (R7), le septième (R7) et le huitième (R8) résonateur, la première $(M_{1,2})$, la deuxième $(M_{2,3})$, la troisième $(M_{3,4})$ inductance étant égale respectivement à la cinquième $(M_{5,6})$, à la sixième $(M_{6,7})$ à la septième $(M_{7,8})$ inductance, en ce qu'il comporte une capacité $(M_{4,5})$ connectée entre le quatrième (R4) et le cinquième (R5) résonateur, et en ce qu'il comporte une inductance $(M_{1,8})$ connectée entre le premier (R1) et le huitième (R8) résonateur, et un condensateur connecté entre le troisième (R3) et le sixième (R6) résonateur.

**Patentansprüch**

Selbstkorrigiertes elektrisches Filter mit Elementen, die lokalisierte Gruppenlaufzeitkonstanten besitzen, dadurch gekennzeichnet, daß es einen ersten (E1) und einen zweiten Eingang (E2), einen ersten Anpassungskondensator (CE) am ersten Eingang (E1) des Filters und acht in Kaskade angeordnete Resonatoren enthält, deren erster einerseits an einen ersten Knoten (N1) und andererseits an den Eingang E2 angeschlossen ist, wobei jeder Resonator aus einem Kondensator (C1) parallel zu einer Spule (L1) besteht, daß das Filter eine erste $(M_{1,2})$, eine zweite $(M_{2,3})$, eine dritte $(M_{3,4})$, eine fünfte $(M_{5,6})$, eine Sechste $(M_{6,7})$ une eine siebte Spule $(M_{7,8})$ enthält, die zwischen dem ersten (R1) und dem zweiten (R2), bzw. dem zweiten (R2) und dem dritten (R3), bzw. dem dritten (R3) und dem vierten (R4), bzw. dem fünften (R5) und dem sechsten (R6) bzw. dem sechsten (R6) und dem siebten (R7) bzw. dem siebten (R7) und dem achten Resonator (R8) angeschlossen sind, wobei die erste $(M_{1,2})$, die zweite $(M_{2,3})$ und die dritte Spule $(M_{3,4})$ je die gleiche Induktivität besitzen wie die fünfte $(M_{5,6})$, die sechste $(M_{6,7})$ und die siebte Spule $(M_{7,8})$, daß das Filter einen Kondensator $(M_{4,5})$ zwischen dem vierten (R4) und dem fünften Resonator (R5) enthält und daß es schließlich eine Spule $(M_{1,8})$ aufweist, die zwischen den ersten (R1) und den achten Resonator (R8) eingefügt ist, sowie einen Kondensator der zwischen den dritten (R3) und den sechsten Resonator (R6) eingefügt ist.

**Claim**

An electrical self-corrected filter having elements with localized group propagation time constants, characterized in that it comprises a first (E1) and a second input (E2), a first matching capacitor (CE) at the first input (E1) of the filter, eight cascade-connected resonators, whereof a first is connected on the one hand to a first node (N1) and on the other hand to the input E2, each resonator being constituted by a capacitor (C1) in parallel with an inductor (L1), that it comprises a first $(M_{1,2})$, a second $(M_{2,3})$, a third $(M_{3,4})$, a fifth $(M_{5,6})$, a sixth $(M_{6,7})$, a seventh $(M_{7,8})$ inductor connected respectively between the first (R1) and the second (R2), the second (R2) and the third (R3), the third (R3) and the fourth (R4), the fifth (R5) and the sixth (R6), the sixth (R6) and the seventh (R7), the seventh (R7) and the eighth resonator (R8), the first $(M_{1,2})$, the second $(M_{2,3})$, the third inductor $(M_{3,4})$ having a respectively equal inductance to the fifth $(M_{5,6})$, the sixth $(M_{6,7})$ and the seventh inductor $(M_{7,8})$, that it comprises a capacitor $(M_{4,5})$ connected between the fourth (R4) and the fifth resonator (R5) and that it comprises an inductor $(M_{1,8})$ connected between the first (R1) and the eighth resonator (R8), and a capacitor connected between the third (R3) and the sixth resonator (R6).

Fig. 1

Fig. 4

Fig. 5

0 057 112

Fig.2

Fig.3

0 057 112

Fig.6